Europäisches Patentamt

European Patent Office

Office européen des brevets

(19)

(11) Publication number: 0 397 460
A2

# EUROPEAN PATENT APPLICATION

(12)

(21) Application number: 90304971.6

(22) Date of filing: 09.05.90

(51) Int. Cl.5: G03F 7/038

(30) Priority: 12.05.89 US 351153

(43) Date of publication of application:
14.11.90 Bulletin 90/46

(84) Designated Contracting States:
AT BE CH DE DK ES FR GB GR IT LI LU NL SE

(71) Applicant: ROHM AND HAAS COMPANY
Independence Mall West
Philadelphia Pennsylvania 19105(US)

(72) Inventor: Bogan, Leonard Edward, Jr.
325 Moyer Road
Herleysville, Pennsylvania 19438(US)
Inventor: Graziano, Karen Ann
162 Willow Lane
Warrington, Pennsylvania 18979(US)

(74) Representative: Angell, David Whilton et al
ROHM AND HAAS (UK) LTD. European
Operations Patent Department Lennig House
2 Mason's Avenue
Croydon CR9 3NB(GB)

(54) Use of highly branched novolaks in photoresists.

(57) A method of using highly branched novolak resins in photoresists is provided. The use of highly branched novolak resins as a film-forming binder component in a photoresist composition has been shown to increase the photospeed and lithographic contrast of the photoresist relative to photoresists containing novolak ploymers having lower degrees of branching. The highly branched novolaks are particularly useful in negative-acting photoresists, and more particularly in negative-acting, acid-hardening photoresists.

EP 0 397 460 A2

## USE OF HIGHLY BRANCHED NOVOLAKS IN PHOTORESISTS

The present invention is concerned with a method of using highly branched novolak resins in photoresist compositions, and more particularly to the use of highly branched novolak resins in the polymeric, film-forming binder of acid-hardening photoresist compositions to achieve improved lithographic performance properties including faster photospeed and higher lithographic contrast.

Novolak (or novolac) resins are commonly used as a component of the film-forming polymeric binder in lithographic compositions, for example in photoresists used for the manufacture of semiconductors.

A photoresist is a composition which is applied as a temporary film on the surface of a substrate material, for example on the surface of a semiconductor wafer, onto which surface a pattern, for example a conductive metal circuit, is imaged. The desired image pattern, corresponding to the boundaries of the circuit, is transferred to the substrate surface by subsequent processing. Alter the desired conductive pattern is incorporated onto the substrate, the portions of the photoresist which remain on the substrate surface are typically no longer needed and are completely removed or stripped from the substrate surface.

An acid-hardening photoresist is a film-forming composition containing a polymeric binder system, a photoacid generating compound and, optionally, a photosensitizer compound. In a negative-acting, acid-hardening photoresist the polymeric binder system contains at least one polymer, such as a novolak, which is capable of crosslinking with itself or with one or more other materials present in the photoresist, for example an aminoplast or phenoplast resin; when the photoresist is heated in the presence of an acid . The photoacid generator incorporated in the photoresist is selected based on its ability to yield a sufficient amount of acid in selected portions of the photoresist film. This crosslinking reaction occurs when the photoresist film is heated after being exposed to, and absorbing, predetermined amounts of preselected types of exposing radiation. Portions of the photoresist film are selectively exposed to actinic radiation, for example light in the ultraviolet spectrum, x-rays, or electron beams, through a stencil or photomask which contains portions which are transparent to the exposing radiation and other portions which are opaque to the exposing radiation; the photomask being positioned between the source of the exposing radiation and the surface of the photoresist film not in contact with the substrate surface. The portions of the negative-acting, acid-hardening photoresist film which are not exposed to the actinic radiation do not contain a sufficient quantity of the generated acid to become crosslinked on subsequent heating. The photoresist is then heated to cause the exposed portions of the photoresist to be crosslinked. The non-crosslinked portions of the photoresist are removed from the substrate surface using a developer solution, preferably an aqueous solution, for example an aqueous solution containing a base. After the non-crosslinked portions of the photoresist film are so removed, the portions of the semiconductor surface not protected by the crosslinked photoresist portions or latent image are then processed, for example, by acid or plasma etching followed by the deposition, in the etched portions, of the conductive material to provide the desired circuitry on the semiconductor surface. Following this step the remaining crosslinked photoresist film portions are completely removed, or stripped, from the substrate surface, preferably using an aqueous solution. Since it is desirable to develop the non-crosslinked photoresist film portions, and to subsequently strip the crosslinked photoresist film portions, using aqueous solutions, rather than by using organic solvent solutions, it is desirable to select the components of the photoresist composition, including the novolak resin, to possess the ability to not only be effectively crosslinked, to form a thermally stable and acid etchant resistant latent image which can be readily stripped after it is no longer needed, but also the ability to be readily removable in the non-crosslinked state.

A detailed description of acid-hardening photoresist compositions and methods for their processing is contained in published EP-A-0164248, EP-A-0232973 and EP-A-0232972 the disclosures of which are hereby incorporated by reference herein.

It is desired that the image pattern created in the photoresist, after selective exposure, development, and crosslinking, be as close as possible to the initial image pattern on the photomask. In the case of conventional photoresists the image pattern in the photoresist often lacks the desired resolution and desired perpendicular side-wall profile. This is particularly problemmatical as the resolution demands of microlithographic applications increase. This problem may be the result of exposing radiation diffraction, backscattering and depth of field problems with the exposing radiation equipment, or the performance limitations of the photoresist itself, or both. Since the resolution of a photoresist directly affects the amount of circuitry which can be placed on the substrate, it would therefore be advantageous to be able to optimize the side-wall profile of the image to be as close to perpendicular to the substrate as possible.

The dissolution rate of the non-crosslinked photoresist portions in the developer solution relative to the dissolution rate of the crosslinked photoresist portions also has an effect on the ultimate resolution capability of the photoresist. In the case of a negative, acid-hardening photoresist the dissolution rate difference is generally improved as compared with conventional positive and negative photoresists because the crosslinking reaction in the exposed photoresist portions effectively increases the dissolution rate differential; or in other words the difference in the solubility, or rate of removal, between the crosslinked and non-crosslinked portions of the photoresist is increased.

It has been found, however, that the dissolution rate of a photoresist can change rapidly with a relatively small change in the actual dose of exposing radiation employed. It is desired that the photoresist have high contrast. By contrast we refer to the difference in exposing radiation dosage needed to achieve a specified change in the dissolution rate. A photoresist which has poor or low contrast effectively reduces the processing lattitude of the photoresist. Low contrast can adversely affect the commercial suitability of an otherwise usable photoresist composition. Although the slowest step in microcircuit manufacture is often the exposure step, high throughput at the imaging step is desirable. A determining factor in the throughput of the imaging step is the length of time needed to adequately expose the entire thickness of the photoresist. A photoresist which requires a low incident dose of exposing radiation is referred to as having a high or fast photospeed. It is desirable, therefore, to maximize both the contrast and photospeed of a photoresist.

Novolak polymers, prepared by conventional synthesis techniques, are typically complex mixtures of polymers formed by the acid catalyzed condensation reaction of phenol with formaldehyde. This reaction proceeds in two steps: the first being the addition of formaldehyde to the unsubstituted ortho and/or para positions on the phenol ring. The second step involves the random joining of the methylol groups, previously added from the formaldehyde to the phenol ring during the first step, with excess phenol to form a mixture of random novolak polymers. Such novolak polymers are typically only slightly branched. For a detailed discussion of novolak resins and their preparation, see Phenolic Resins, A. Knop and L.A. Pilato, Chapter 3, Springer-Verlag, N.Y. (1985).

More highly branched novolak polymers are known, but have not been previously proposed or suggested for use in photoresists. These polymers may, for example, be prepared by the acid catalyzed condensation of methylol-reactive phenols with tri- or tetra-methylol diphenols. See, for example, US-A-4,474,929 and US-A-4,468,507.

We have now found that highly branched novolak polymers, when incorporated in photoresist compositions, can provide photoresist compositions with improved lithographic performance, as compared with the conventional novolaks currently employed in such photoresist compositions, and that this may be achieved without adversely affecting the other desirable processing characteristics of the photoresist. For Example, negative-acting, acid-hardening photoresists, containing highly branched novolaks, can be provided which exhibit high contrast and photospeed.

According to the present invention there is provided a novolak:-containing photoresist composition having increased lithographic performance, characterized in that the novolak comprises an effective amount of highly branched novolak resin.

By focusing on the structure of the novolak resins used in photoresist compositions, the present invention enables the resolution, dissolution rate, contrast and photospeed of the photoresists, and particularly of negative-acting, acid-hardening photoresists, to be improved.

As used herein, a novolak resin is considered to be "highly branched" if at least twenty percent (20%) of the phenolic rings in the polymer chain are bound directly to three different methylene groups, each of which group being bound to another phenolic ring. The fraction of branching rings in a highly branched novolak: resin can be directly determined for m-cresol rings using a Carbon-13 NMR technique. A solution of 0.2 grams of the resin in 0.4 milliliters of $d_8$-dioxane is analyzed by acquiring its $^{13}C$ NMR spectrum, using an inverse-gated pulse sequence with a $60^0$ pulse width and a four second pulse delay. The methyl carbon resonances are integrated, and the area under the resonance at about 15.7 parts per million relative to tetramethylsilane (TMS) is divided by the sum of the areas under all of the methyl carbon resonances; this ratio, in the case of a m-cresol novolak homopolymer, being the fraction of branch rings in the resin.

The highly branched novolaks may be prepared by the conventional acid-catalyzed reaction of formaldehyde with phenol or by reacting phenol with a large excess, for example 3 to 4 molar equivalents, of formaldehyde in a basic medium, for example by using a metal hydroxide to form tris(hydroxy methyl) phenol. The tris(hydroxy methyl) phenol may then be reacted with additional phenol in an acidic medium to form the highly branched novolak. Alternatively, the reaction can be conducted using a secondary amine base instead of the metal hydroxide to form tris(dialkylaminomethyl)phenol, which can then be reacted with additional phenol to form a highly branched novolak. Other synthesis techniques for preparing highly branched novolaks include those described in US-A-4,474,929, US-A-4,468,507, US-A-4,256,844 and USSR Patent No. 1154297.

A method, which may be operated in such a way as to prepare highly branched novolaks suitable for use in the present invention, is the acid catalysed reaction of certain specific phenols which is disclosed in our copending European Patent Application filed herewith (claiming priority from U.S. Serial No. 351,154).

The photoresist composition typically contains at least 50 percent by weight of non-reactive solvent, for example a non-reactive solvent selected from glycolethers such as ethylene glycol monomethylether, ethylene glycol monoethylether, Propasol P and Propasol B; Cellosolve esters such as methyl Cellosolve acetate, ethyl Cellosolve acetate and acetates of Propasol B and P; aromatic hydrocarbons such as toluene and xylene; ketones such as methylethyl ketone, cyclopentanone and cyclohexanone; esters such as ethyl acetate, butyl acetate, isobutyl isobutyrate and butyrolactone; amides such as dimethylacetamide (DMAC), N- methylpyrrolidinone (NMP) and dimethylformamide(DMF); chlorinated hydrocarbons such as ethylene dichloride, chlorobenzene and ortho-dichlorobenzene; nitrobenzene; dimethylsulfoxide; and mixtures thereof.

The highly branched novolak: resin is preferably present, in the photoresist composition, in an amount of about 40 to about 90 percent by weight, based on the weight of the solids in, or non-solvent components of, the composition.

In preparing a photoresist composition containing the highly branched novolak, and more particularly for preparing an acid-hardening photoresist, the highly branched novolak should preferably have a weight average molecular weight in the range of from about 300 to about 100,000, and more preferably from about 1000 to about 20,000. The acid-hardening resin system of the photoresist preferably contains, in addition to the highly branched novolak, at least one other resin which can undergo acid catalyzed crosslinking with the highly branched novolak, for example an aminoplast or phenoplast resin. Examples of suitable aminoplast resins include urea-formaldehyde, melamine-formaldehyde, benzoguanamine-formaldehyde and glycoluril-formaldehyde resins and combinations thereof. Polymeric aminoplast resins, such as those prepared by the reaction of acrylamide or methacrylamide copolymers with formaldehyde in an alcohol-containing solution, or by the copolymerization of N-alkoxymethyl acrylamide or methacrylamide with other suitable monomers may be used.

In an acid-hardening photoresist composition the concentration of the acid-hardening resin system ranges from about 40 to about 95 weight percent of the photoresist excluding the solvent.

When the novolak is combined with an aminoplast or phenoplast resin, the aminoplast or phenoplast resin usually comprises from about 3 to about 50 percent by weight, and the novolak from about 40 to about 90 percent by weight, of the non-solvent components.The remainder of the non-solvent components of the photoresist composition is made up of the photoacid generating compound and the optional photosensitizer.

The photoacid generating component is selected based on its ability to: absorb actinic radiation in the wavelength range of the desired exposing radiation to be employed; be compatible with the acid hardening resin system; be developable in a solvent selected for developing the photoresist film, preferably an aqueous solution; ahd be capable of generating a sufficient concentration of acid ,upon the exposure of the photoresist, to act as a catalyst for the crosslinking reaction in the acid-hardening resin system. Many suitable photoacid generators have been identified for use in negative-acting, and acid-hardening, photoresists. For example, diazonaphthoquinones which generate weak: carboxylic acid upon exposure to ultraviolet radiation in the near UV wavelength range of from about 300 to about 500 nanometers have been used as photoacid generators in negative-acting, acid-hardening photoresists. Certain halogenated organic compounds are highly sensitive to shorter wavelength radiation, such as deep UV, x-ray, and electron beam radiation, and may be employed as photoacid generators, such as tris(2,3-dibromopropyl)isocyanurate and the other compounds disclosed in EP-A-0232972 and EP-A-0232973.

Lithographic potential is an important measure of the performance of a photoresist. Lithographic potential is defined as the logarithm of the ratio of the dissolution rates of the unexposed and exposed portions of the photoresist film. Lithographic potential is typically plotted as a function of the incident dose of exposing radiation. The higher the lithographic potential the greater the differentiation between exposed and unexposed regions. When the lithographic potential (y-axis) is plotted as a function of the incident exposure dose (milliJoules per square centimeter) (x-axis), the slope of the curve is equal to the contrast of the photoresist; the higher the slope the higher the contrast; or in other words the lower the difference in exposing dose needed to achieve the same difference in lithographic potential of the photoresist.

The present invention will now be further illustrated by way of the following Examples which are for illustrative purposes oniy and are not to be construed as imposing any limitation on the scope of the invention. Example 1 illustrates the improvement in the photospeed and contrast of a negative-acting, acid-hardening, photoresist as a function of the increase in the degree of branching of the novolak resin employed.

Example 1

Two negative-acting, acid-hardening, photoresists were prepared; one containing a m-cresol novolak resin having a 14% branch fraction (comparative) and the other having a m-cresol novolak having a 21% branch fraction. The compositions of the photoresists were otherwise identical, as described below.The extent of branching of each of the novolaks was determined using the Carbon-13 NMR technique described hereinbefore.

The photoresist composition used was as follows: 16 grams of the meta-cresol novolak, 64 grams of Shipley Company Microposit Thinner Type A cellosolve acetate solvent, 0.99 grams tris (2,3-dibromopropyl)isocyanurate photoacid generator, and 2.82 grams Cymel 1170 glycoluril-formaldehyde resin.

Each of the photoresist compositions were separately spin coated onto 7.62 cm (3 inch) HMDS vapor-primed silicon wafers at 3000 revolutions per minute for 60 seconds.The coated wafers were then softbaked on a 70 degree Centigrade hotplate for 60 seconds. The softbaked coated wafers were then exposed to 254 nanometer light through a band-pass filter and Optoline Step-Wedge Mask photomask at an incident exposure dosage of 10 milliJoules per square centimeter. Since the Step-Wedge Mask varies the percent transmission from 0% to 60% of the incident dose the actual dosage per wafer ranged from 0 to 6 milliJoules per square centimeter The exposed wafer was then postbaked at a temperature of 100 degrees Centigrade for 60 seconds on a hotplate. The photoresist was then developed using 0.135 Normal tetramethylammonium hydroxide aqueous solution (Shipley Company MF-322 developer). Development was monitored using a Perkin-Elmer Dissolution Rate Monitor. Lithographic potential was then determined by calculating the difference between the log (unexposed dissolution rate) and the log (exposed dissolution rate).

Table 1 below presents the lithographic performance of the two negative-acting, acid -hardening, photoresist compositions as a function of exposure dose of both photoresists.

Table 1

| Exposure dose (milliJoules) | Lithographic Potential | |
|---|---|---|
| | 21% Branched | 14% Branched (comparative) |
| 0.0 | 0.0 | 0.0 |
| 0.5 | 0.15 | 0.0 |
| 1.0 | 0.63 | 0.03 |
| 1.2 | 0.93 | 0.15 |
| 1.4 | 1.15 | 0.19 |
| 1.6 | 1.38 | 0.41 |
| 1.8 | 1.58 | 0.63 |
| 2.0 | 1.71 | 0.75 |
| 2.2 | 1.85 | 1.0 |
| 2.5 | 1.97 | 1.17 |
| 3.0 | 2.05 | 1.29 |
| 3.5 | 2.07 | 1.37 |
| 4.0 | 2.14 | 1.51 |
| 5.0 | 2.21 | 1.7 |
| 6.0 | 2.23 | 1.84 |

As evident from Table 1 the lithographic potential of the photoresist containing the highly branched novolak resin was significantly greater than that of the photoresist containing the lower fraction branched novolak at the same exposure dose thereby illustrating the photospeed improvement. The difference in exposure dose needed to achieve the same change in lithographic potential was lower in all instances for the photoresist containing the highly branched novolak than for the photoresist containing the novolak containing a lower branch fraction, thereby illustrating the contrast improvement resulting from the use of the highly branched novolak- containing photoresist.

### Example 2

The lithographic potential of negative- acting, acid-hardening photoresist compositions containing other highly branched novolaks was evaluated utilizing the photoresist composition of Example 1 with different highly branched novolaks being substituted for the ones used in Example 1. All other process steps and evaluations were the same as in Example 1.

A 40 % branched novolak and a 37% branched novolak , as determined by Carbon-13 NMR, having the composition 72 wt % m-cresol and 28 wt% phenol were used.

The lithographic performance of these photoresist compositions are shown in Table 2.

Table 2

| Exposure Dose(mJ) | Lithographic Potential | |
|---|---|---|
| | 37% | 40% |
| 0.0 | 0.0 | 0.0 |
| 0.5 | 0.0 | 0.0 |
| 1.0 | 0.18 | 0.03 |
| 1.2 | 0.45 | 0.15 |
| 1.4 | 0.72 | 0.33 |
| 1.6 | 1.17 | 0.67 |
| 1.8 | 1.53 | 1.07 |
| 2.0 | 1.86 | 1.41 |
| 2.2 | 2.23 | 1.77 |
| 2.5 | ------ | 2.23 |

### Example 3 Positive Photoresist

A positive-acting, acid -hardening photoresist was prepared from 20.35 grams of a highly branched (22.5%) meta-cresol novolak resin with 6.65 grams of a naphthoquinone diazide photoacid generator dissolved in 73.0 grams of Cellosolve acetate solvent. The photoresist solution was spun onto a 7.62 cm (3 inch) silicon wafer to form a 1 micrometer thick coating. The photoresist coating was then exposed through a positive, Step-Wedge photomask to near ultraviolet radiation having a wavelength of 436 nanometers.The exposed photoresist coating portions were removed by developing the photoresist coating using a 0.1 N aqueous solution of tetramethylammonium hydroxide developer. The minimum exposure dosage needed to remove the exposed portions was 84.9 mJ/cm$^2$, and the photoresist contrast was measured to be 3.07.

## Claims

1. A novolak-containing photoresist composition having increased lithographic performance, characterized in that the novolak comprises an effective amount of highly branched novolak resin.

2. A novolak-containing photoresist composition as claimed in claim 1, wherein the extent of branching of the highly branched novolak resin is such that at least 20 percent of the phenolic rings in the polymer chain are bound directly to three different methylene groups, each of which group is bound to another phenolic ring.

3. A novolak-containing photoresist composition as claimed in claim 1 or claim 2, which is in the form of a negative-acting photoresist composition.

4. A novolak-containing photoresist composition as claimed in any preceding claim, wherein the highly branched novolak resin has a weight average molecular weight of from about 300 to about 100,000, preferably from about 1,000 to about 20,000.

5. A novolak-containing photoresist composition as claimed in any preceding claim, which comprises non-reactive solvent, for example in an amount of at least 50 percent by weight of the composition.

6. A novolak-containing photoresist composition as claimed in any preceding claim, which comprises acid-hardening resin system, photoacid generating compound, and, optionally photosensitizer, and wherein said acid-hardening resin system comprises the highly branched novolak resin, optionally, together with at least one other resin capable fo undergoing acid-catalysed crosslinking with the highly branched novolak.

7. A novolak-containing photoresist composition as claimed in claim 6, wherein the acid-hardening resin system is present in an amount of from about 45 to about 95 weight percent, based on the weight of the photoresist composition, excluding any solvent present.

8. A novolak-containing photoresist composition as claimed in claim 6 or claim 7, wherein said other resin(s) is aminoplast or phenoplast resin.

9. A novolak-containing photoresist composition as claimed in claim 8, wherein the highly branched novolak resin is present in an amount of from about 40 to about 90 percent by weight, and the aminoplast or phenoplast resin is present in an amount of about 3 to about 50 percent by weight, the percentages being based on the weight of the photoresist composition, excluding any solvent present.

10. A novolak-containing photoresist composition as claimed in any of claims 1 to 8, wherein the highly branched novolak is present in an amount of from about 40 to about 90 percent by weight, based on the weight of the photoresist composition, excluding any solvent present.

11. A novolak-containing photoresist composition as claimed in any preceding claim wherein said highly branched novolak resin is prepared by:

(i) the acid catalyzed condensation of methylol-reactive phenols with tri-or tetra-methylol diphenols;

(ii) reacting tris(hydroxy methyl) phenol with phenol in an acidic medium; or

(iii) reacting tris(dialkylaminomethyl)phenol with additional phenol.

12. The use of a highly branched novolak resin to increase the lithographic performance of a photoresist composition.